# EUROPEAN PATENT APPLICATION

(11) **EP 4 783 812 A1**
(43) Date of publication of application: **29.07.2026**
(21) Application number: 26152518.2
(22) Date of filing: 19.01.2026
(51) Int. Cl.: H10P 72/10

(54) **A STORAGE SYSTEM FOR STORING A PLURALITY OF SUBSTRATE HOLDERS**

(30) Priority: 22.01.2025 IT 202500001116
(71) Applicant: L.P.E. S.p.A., 20021 Baranzate (MI) (IT)
(72) Inventor: CECILI, Alessandro, Milano (IT); POLLI, Stefano, Milano (IT); MESCHIA, Maurilio Giuseppe, Asti (IT)
(74) Representative: Buzzi, Notaro & Antonielli d'Oulx S.p.A.

(57) **Abstract**

The present disclosure relates to a storage system (100) suitable for storing a plurality of substrate holders (130), where the storage system includes a pin (308) extending along a rotation axis, at least two shelves (110) positioned along a direction substantially parallel to the rotation axis, each shelf being adapted to support at least one removable housing (120). The shelves are pivotally connected to the pin around the rotation axis and are configured to rotate around said rotation axis independently from each other. Each removable housing is adapted to support at least one substrate holder suitable for supporting a substrate (616) for the deposition of semiconductor films, said removable housing being configured to be releasably coupled to a shelf and be withdrawn therefrom. The present disclosure also relates to a substrate handling platform (602) comprising said storage system (100) and a reactor assembly (600) comprising said substrate handling platform (602).

## Description

### FIELD OF INVENTION

The present invention relates to a storage system for a substrate handling platform of a reactor assembly, and a substrate handling platform and a reactor assembly comprising said storage system.

### BACKGROUND OF THE DISCLOSURE

Substrates intended to undergo deposition processes of semiconductor material in a reactor are generally stored and transported within cassettes, in which the substrates are stacked and spaced apart from each other.

These cassettes generally include an open side, accessible externally for loading and unloading substrates from the cassette, and an opposite totally or at least partially enclosed rear side.

Prior to being processed in a reaction chamber of a reactor, the substrates are coupled to a substrate holder, which is used to prevent direct contact with the substrates when they are handled and displaced within a reactor assembly. The substrate holders thus prevent the substrates from contamination and scratches.

The substrate holders may be handled manually or with specifically designed automated means, such as robotic arms, adapted to grab and displace the substrate holders, with or without a substrate, within a reactor assembly.

Typically, the substrate holders exhibit a substantially circular shape adapted to hold the substrate without undesired displacements, and optionally to orient the substrate according to a predetermined refence.

The substrate holders may exhibit a closed, open, or partially open bottom surface, which may be flat or concave. Preferably, the substrates are placed over the substrate holders, but the contact points between the substrate and the substrate holder should be limited to a few peripheral points, segments, or small areas.

The substrate holders may be further equipped and topped with rings (removable or fixed) to protect the edges of the substrates during deposition.

Typically, the substrate holders and the substrates, generally contained in one or more cassettes, are placed on a substrate handling platform comprising a centering unit.

In the centering unit, a substrate is placed (and optionally centered and/or oriented in a predetermined fashion) on a substrate holder, before being further displaced for processing.

The substrate holders are typically arranged on a rack, on top of each other, and spaced apart from each other to allow easy handling and avoid particle generation.

The substrate holders may require substitution for cleaning and disposal after a certain number of uses inside the reaction chamber.

For example, in SiC epitaxial reactors the replacement of individual substrate holders may occur quite frequently because of parasitic deposits on the parts exposed to process gases, if any. These exposed parts often include the top protection ring of the substrate holder, if present.

With the racks used in the art, all substrate holders contained in the rack are uploaded and unloaded from the substrate handling platform together.

However, this "bulk" upload and unload of substrate holders does not allow to substitute them singularly or in smaller batches of maximum 1-6 substrate holders, preferably 1-4, based on their actual need for handling or replacement.

Additionally, the racks used in the art usually have a front side accessible from the outside for the loading and unloading of substrate holders, and an opposite rear side at least partially closed. The relative position and orientation of the front and back side is fixed, and it is the same for all substrate holders, regardless of the type of operation being conducted (upload/unload operations related to the processing of the substrates versus replacement and handling of the substrate holders by an operator).

Therefore, there is a need to provide a storage system for substrate holders capable to optimize the replacement of substrate holders in a substrate handling platform of a reactor assembly.

There is also a need for a storage system that simplifies the loading and unloading of one or more substrate holders.

There is also a need for a storage system that simplifies the transportation of the substrate holders.

There is also a need to have a storage system that minimizes the risk of contamination or damage to substrate holders before or after having been used in the deposition process.

There is also a need to have a substrate handling platform equipped with a storage system that offers multiple access points to the substrate holders.

There is also a need to have a reactor assembly provided with said substrate handling platform.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present invention to overcome the disadvantages of the prior art.

In particular, it is an object of the present invention to provide a storage system that may improve the replacement of substrate holders in a substrate handling platform of a reactor assembly.

It is another object of the present invention to provide a storage system that may simplify the loading, unloading and transportation of one or more substrate holders.

It is another object of the present invention to provide a storage system that may minimize the risk of contamination or damage to substrate holders before or after use in the deposition process.

It is another object of the present invention to provide a substrate handling platform equipped with a storage system that may offer multiple access points to the substrate holders.

It is another object of the present invention to provide a reactor assembly comprising the substrate handling platform.

The main objectives hereinbefore described are achieved through the invention recited in the appended claims, which constitute an integral part of the present description.

It is noted that the use of reference signs in the claims does not limit their scope. The sole purpose of reference signs is to make the claims easier to understand.

### BRIEF DESCRIPTION OF THE FIGURES

The illustrations presented herein are not meant to be actual views of any particular material, structure, or device, but are merely idealized representations that are used to describe embodiments of the disclosure.
FIG. 1 provides a schematic illustration of a storage system 100 according to one embodiment of the invention.
FIG. 2 provides a schematic illustration of a storage system 100 according to one embodiment of the invention.
FIG. 3 provides a schematic section of a storage system 100 according to one embodiment of the invention.
FIG. 4 provides a schematic illustration of a part of the storage system 100 according to one embodiment of the invention.
FIG. 5 provides a schematic section of a storage system 100 according to one embodiment of the invention.
FIG. 6 provides a schematic illustration of a reactor assembly 600 according to one embodiment of the invention.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Reference will now be made to the Figures wherein like reference numerals identify similar structural features or aspects of the subject disclosure. It is noted that the use of reference signs in the description does not limit the description to the illustrated embodiments.

In particular, it will be appreciated that elements in the figures are illustrated for simplicity and clarity. Some elements may have been omitted or may have not been drawn to scale. For example, the dimensions of some of the elements in the figures may be exaggerated relative to other elements to help improve understanding of illustrated embodiments of the present disclosure.

Other technical features may be readily apparent to one skilled in the art from the following figures, descriptions, and claims.

In one aspect, the present invention relates to a storage system 100 suitable for storing, and optionally displacing, a plurality of substrate holders 130.

The storage system includes a pin 308 extending along a rotation axis (z), at least two shelves 110 stacked in a direction parallel, or substantially parallel, to the rotation axis (z).

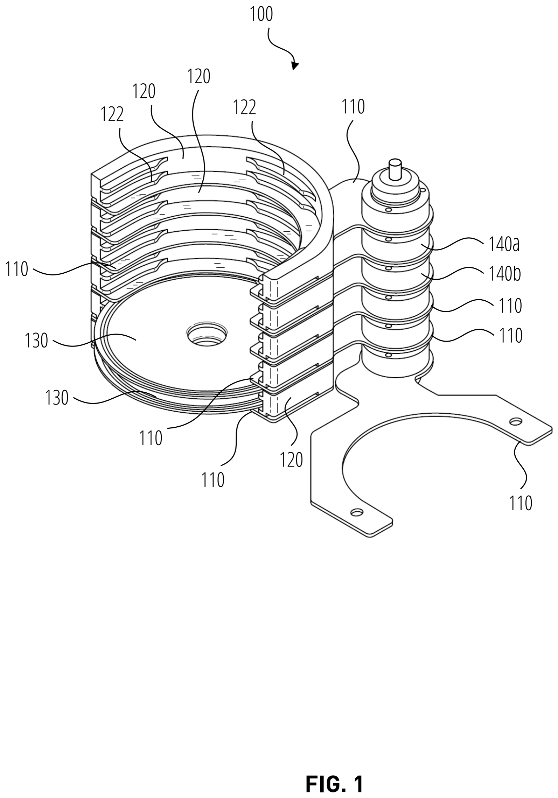

By "stacked in a direction parallel to the rotation axis (z)" it is meant that the shelves are placed on top of each other along the direction z (but not necessarily in direct contact), while each shelf extend in parallel planes substantially perpendicular to z, as apparent from FIG. 1 to FIG. 5.

By "substantially parallel" or "substantially perpendicular" it is meant a direction or plane that is respectively parallel or perpendicular with a +/-5% tolerance.

The shelves are pivotally connected to the pin around the rotation axis and are configured to rotate around the rotation axis independently from each other.

Each shelf is adapted to support at least one removable housing 120.

Each removable housing is adapted to support at least one substrate holder 130 suitable for supporting a substrate 616 for the deposition of semiconductor films.

Each removable housing is configured to be releasably coupled to the shelf and be withdrawn therefrom, for example via mechanical (automated) and/or manual means.

By "releasable coupling" it is meant that the removable housing, when it is placed on the shelf, can:
(a) move together with the shelf when the latter is set in motion (the shelf can be set in rotatory motion around the pin either manually or through a drive motor connected to each shelf); and
(b) be released from the shelf by an operator or automated means, for example a robotic arm optionally equipped with an end effector.

Steps (a) and (b) can be repeated multiple times without detriment to either the shelf and/or the removable housing.

Preferably, the generation of particles during steps (a) and (b) should be minimized, by favoring simple joining mechanism which require little or no rubbing and/or wiggling of the parts involved (namely the removable housing and the shelf).

For example, step (a) may rely on the gravity of the substrate holder to ensure it moves integrally with the shelf. Alternatively, simple interlocking means, such as matching protrusions and indentations on the contacting surfaces of the removable housing and the shelf may ensure the substrate holder is not displaced from a nominal position during the rotation of the shelf. These matching protrusions and indentations may also be used to guide the nominal placement of the removable housing on the shelf. Stop mechanisms may be also used.

Advantageously, the storage system according to the invention allows to retrieve and transfer a subset of substrate holders, for example only the ones contained in the removable housings releasably coupled to a shelf, to improve the efficiency and continuity of the deposition process.

Indeed, contrary to the storage systems known in the art, which require to clean and/or substitute all substrate holders at once, the storage system according to the invention allows to replace and handle a fraction of substrate holder, to more efficiently follow the actual deposition process, use a lower amount of substrate holders and reduce/avoid downtime.

Exemplary embodiments of the storage system 100 according to the invention, or selected parts thereof, are schematically illustrated in FIG. 1 - FIG. 5.

Preferably, each removable housing is adapted to support 1-6 substrate holders, even more preferably 1-4.

Preferably, the substrates 616 are suitable for the epitaxial or CVD deposition of semiconductor films.

Preferably, each shelf is adapted to support 1-3 removable housings, even more preferably each shelf supports one removable housing. This limits the number of removable housings extracted/inserted in the storage system, as each shelf is rotated around the pin for accessing its contents. The removable housings may be adapted to be stacked one on top of the other.

Preferably, the number of shelves is 2-20; even more preferably 3-10.

Advantageously, the storage system according to the invention may improve the replacement of substrate holders in a substrate handling platform of a reactor assembly.

It may be advantageous to minimize contact and friction between adjacent shelves. This may be achieved by avoiding having the shelves (or parts thereof, such as the hubs 140) directly rub against each other when rotating. This may be achieved in many ways.

For instance, friction-less or low friction separators may be interposed between adjacent shelves. Non limiting examples of suitable separators include rolling bearings (such ball and/or roller bearing systems), and/or seegers inserted or attached to the pin. In the latter case, the pin may feature suitable indentations to partially support each seeger positioned between two adjacent shelves.

Preferably, each shelf offers a supporting surface parallel to a plane (xy) substantially perpendicular to the rotation axis.

Preferably, the pin is made of stainless steel.

Preferably, the shelves are made of aluminum or stainless steel.

Preferably, the removable housing is made of aluminum or plastic, for example a commodity plastic such as PVC, polypropylene, polyethylene, POM-C, Nylon, and/or Teflon.

The rotation axis (z) may be oriented in a vertical direction and the plane (xy) is a horizontal plane perpendicular to (z).

Under an embodiment, each removable housing 120 of the storage system 100 features a front side 123, and the front side faces an outer side of the storage system.

In principle, both the substrate holders and the removable housings may be extracted from the front side via manual or automated means, such as a robotic arm, optionally equipped with an end effector.

Preferably, the front side is adapted to engage with a robotic arm, optionally equipped with an end effector, or any automated means configured to pick up a substrate holder and displace it - for example to a substrate centering unit 610 of a reactor assembly 600.

Advantageously, this allows to minimize the risk of contaminating the substrate holder before it is coupled to a substrate for processing.

Preferably, the front side may be adapted to also engage with an operator, for the manual extraction/insertion of one or more removable housings from/to the storage system 100, and specifically from its shelves. The operator may then displace the removable housing and proceed with the retrieval and transfer of the substrate holders contained therein, for cleaning or substitution.

Advantageously, this allows to minimize the risk of contaminating the substrate holder, by having the operator handle the removable housing instead of the substrate holders.

With further advantage, the operator may thus easily retrieve and transfer a subset of substrate holders contained in the removable housing, instead of all substrate holders in the storage system, thus improving the efficiency and continuity of the deposition process.

Preferably, at least one side of the removable housing 120 parallel to the plane (xy) is open or substantially open (i.e., exposing more than 80% of a substrate holder top and/or bottom surface when placed in the removable housing). Even more preferably, at least its top (upper) side is open or substantially open in the (xy) plane. Advantageously, access to the substrate holders is thereby facilitated.

In the preferred example described above, the removable housing may further comprise a lid adapted to close the top surface of the removable housing when the latter is displaced. The lid may be advantageously configured to releasably couple with the removable housing, for example by a releasable locking mechanism, and may optionally comprise one or more handles to facilitate transportation.

Alternatively, the removable housing may be closed or substantially closed (i.e., at least 95%) in the plane (xy) to avoid particles contaminating the substrate holders positioned in below.

Under an embodiment, the removable housing 120 includes at least one supporting element 122 for supporting at least one substrate holder 130.

Preferably, each supporting element comprises one or more protrusions or indentations defining one or more contact areas or points capable to hold a substrate holder and possibly prevent undesired displacements.

Preferably, each supporting element is configured to support a substrate holder of circular or substantially circular shape. By substantially circular shape it is meant a substrate that has a circular projection on at least one plane, with local deviations from a constant radius in that plane less or equal to 10% of said radius.

Advantageously, the use of protrusions and indentations to support a substrate holder facilitate its manual or automatic insertion and removal and are cost effective to manufacture.

Preferably the removable housing 120 comprises 1-6 supporting elements, preferably 1-4, each supporting element being adapted to support one substrate holder and consisting of a plurality of protrusions.

The supporting element can be manufactured in the removable housing inner surface, i.e., the surface facing the substrate holder when the latter is in the removable housing.

Preferably, the supporting element is adapted to contact a very small fraction of the substrate holder, for example less than 20% of its bottom surface, preferably less than 10%, even more preferably, less than 5%. The inventors observed that a reduced overlap between the substrate holder and the supporting element allows to reduce dust or dirt generated by friction between contacting parts.

Under an embodiment, each shelf 110 is adapted to rotate from at least a first predetermined position to at least a second predetermined position and vice versa.

Advantageously, a storage system having its shelves rotate between at least two predetermined positions, offers different points of access to the removable housings and/or the substrate holders and different ways to accessing them. They allow to physically separate the area where a machine or a user handles the removable housings with respect to the area where the same or different machine or user handles the substrate holders.

Under an embodiment, each shelf 110 can be releasably locked into said first predetermined position and/or said second predetermined position.

For example, a stop mechanism may be used, alone or in combination with a magnetic lock system. The storage system may comprise a column 508 of ferromagnetic material, and the shelves may be equipped with magnets. The magnets and the column of ferromagnetic material can be positioned in a way to magnetically attract the shelves in proximity of the column into a releasably locked position.

Advantageously, this magnetic lock mechanism is effective from a cost, use and manufacturing standpoint.

Under an embodiment, each shelf 110 includes a hub 140, 140a, 140b configured to be pivotally connected to the pin 308.

Advantageously, this design provides a particularly stable storage system, by avoiding or minimizing fluctuations of the shelves during movement or under the weight of the removable housings, with or without the substrate holders. This is especially important if automatic handling means are used to grab and displace the removable housings and/or the substrates, since it ensures a reliable and reproducible positioning of the shelves and their contents.

Preferably, every hub 140, 140a, 140b includes a bush 302.

Advantageously, the bush may minimize the friction between the hub and the pin

Under an embodiment, the storage system 100 further includes at least one separator 306 placed between two adjacent hubs 140a, 140b.

Optionally, each separator 304 comprises rolling bearings (such as a ball and/or roller bearing systems) contacting adjacent hubs.

Advantageously, the above embodiments minimize friction and hence the risk of creating debris, which is a source of substrate contamination.

Under an embodiment, the storage system 100 further includes a first sensor 502 configured to detect when all shelves 110 are in the first predetermined position and/or in the second predetermined position.

Optionally, the first sensor may be connected to means for notifying the user when the condition is or is not met. For example, the first sensor may be connected to a processing unit and optionally: a user interface, an acoustic device, and/or an indicator light.

Under an embodiment, the storage system 100 further includes a second sensor 504 configured to detect a displacement of one or more substrate holders 130 from a predefined location when all shelves are either in the first predetermined position or in the second predetermined position.

Preferably, the first sensor and/or the second sensor is an optical sensor, such as a laser sensor.

Under a second aspect, the present invention relates to a substrate handling platform 602 for a reactor assembly 600.

The substrate handling platform includes:
- a support surface 506;
- at least one storage system 100 according to any of the embodiments hereinbefore described;
- at least one substrate centering unit 610;
- at least one automatic component 612 adapted to grab and displace a substrate holder 130.

The storage system, the substrate centering unit, and the automatic component are positioned on the support surface and are mutually arranged so that both the storage system and the substrate centering unit can be accessed by the automatic component. For instance, the automatic component 612 may be arranged so to grab and transfer a substrate holder 130 from the storage system 100 to the substrate centering unit 610, and/or vice versa.

The automatic component can be a robot, for example an articulated arm, optionally equipped with an end effector.

The substrate centering unit is a device adapted to couple a substrate with a substrate holder.

Optionally, the centering unit may be adapted to align or center the substrate on the substrate holder according to a predefined position and/or orientation.

The support surface is a substantially flat surface, for example a tabletop, adapted to support the storage system, the centering unit and the automatic component.

It may optionally comprise a damping mechanism to absorb and dissipate vibration energies across a broad range of frequencies.

For instance, the substrate handling platform 602 may be used as follows. When the shelves 110 of the storage system 100 are in the first predetermined position, and the substrate holders are inserted in the removable housings on the shelves, the automatic component 612 may grab the substrate holder 130 from the removable housings 120 to be transferred to the substrate centering unit 610 for coupling with a substrate 616.

When the shelves 110 are in the second predetermined position, an operator may insert a removable housing 120 containing new or cleaned substrate holders for further use. Alternatively, the operator may remove a removable housing with the used substrate holders for cleaning or disposal.

Optionally, the removable housing 120 may be equipped with a lid or cover to protect the substrate holders when the removable housing 120 is handled and/or displaced by an operator.

When each removable housing has a front side 123 and said front side faces an outer side of the storage system, it is convenient to have the front side face the automatic component 612 when in a predetermined position, such as a first predetermined position.

Advantageously, the substrate handling platform 602 provides a compact and automated solution for coupling (and optionally aligning) a substrate with a substrate holder.

Under an embodiment, the substrate handling platform 602 further comprises a substrate management station 614 for receiving and storing substrates 616. For example, the substrate management station 614 may be adapted for receiving cassettes storing a plurality of substrates.

The substrate management station 614 is positioned over the support surface 506 and it is arranged so that it can be accessed by an automatic component 612.

Preferably, the substrate management station 614 can be configured to be interfaced with automated loading and unloading systems, such as a SMIF, AGV or AMR systems, or with an operator. The access point of the operator or the automated loading and unloading systems may advantageously differ from the access for the automatic component 612. This may be achieved by equipping the substrate management station 614 with a rotation mechanism.

Advantageously, this embodiment provides a compact and fully automated solution for coupling (and optionally aligning) a substrate holder with a substrate from a substrate management station 614 before processing (and, vice versa, to uncouple them after the deposition process).

Under a third aspect, the present invention relates to a reactor assembly 600 comprising:
- at least one substrate handling platform 602 as hereinbefore described;
- a reactor for the deposition of semiconductor films on a substrate 616 comprising at least one reaction chamber 608;
- at least one load-lock chamber 604 for conditioning substrates; and
- at least one transfer chamber 606 connected to the reaction chamber 608 and to the load-lock chamber 604.

The load-lock chamber can be advantageously equipped with means for depressurizing and flushing in argon said chamber, in order to condition the substrate before processing.

The transfer chamber 606 comprises an automatic component 612.

This automatic component can be used to grab and transfer a substrate holder 130, typically supporting a substrate 616, in and out of the reaction chamber.

Preferably, this automatic component can be used to displace the substrate holder to/from the load-lock chamber 604 from/to the reaction chamber 608.

This operation can be performed directly or indirectly, by placing the substrate holder in a cooling station 618 and/or a heating station 620 optionally comprised in the reactor assembly 600.

The reactor can further comprise any other suitable additional elements to ensure its correct operation. For example, the reactor may comprise a heating apparatus configured to heat the reaction chamber; and a gas panel for delivering process gases into the reaction chamber, one or more vacuum pumps for controlling the pressure, valves, gas panels, and circuitries.

In a non-limiting example, the reactor is an epitaxial reactor for the deposition of silicon carbide. The reaction chamber may be a horizontal, optionally hot wall, single substrate reaction chamber. The heating apparatus may be an induction system.

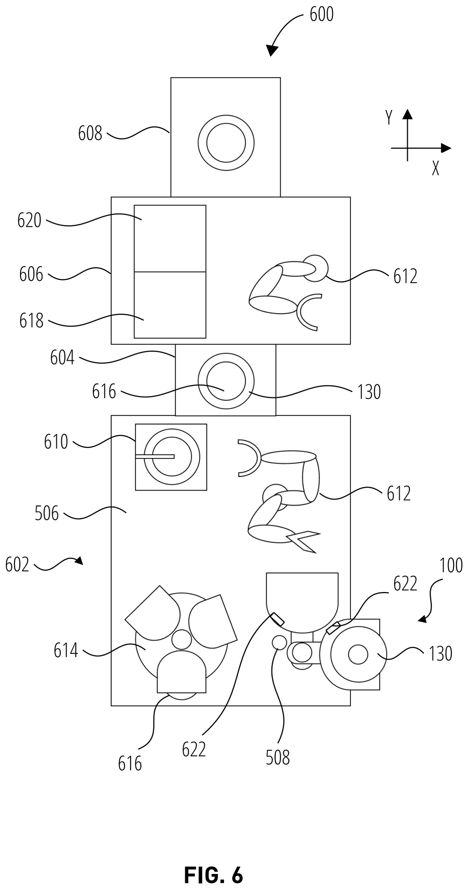

Exemplary embodiments of the reactor assembly 600 according to the invention and of a substrate handling platform 602 comprised therein are schematically illustrated in FIG. 6.

The subject matter of the present disclosure includes all novel and nonobvious combinations and subcombinations of the various processes, systems, and configurations, and other features, functions, acts, and/or properties disclosed herein, as well as any and all equivalents thereof.

### DESCRIPTION OF THE FIGURES

FIG. 1 provides a schematic illustration of a storage system 100 according to an embodiment of the invention. Not all elements are numbered or visible. The storage system 100 comprises six shelves 110. Five shelves support a removable housing 120 each and are placed in a first predetermined position. One empty shelf 110 is rotated at 90° with respect to the others and is placed in a second predetermined position. Each removable housing comprises a plurality of supporting elements 122 adapted to support a substrate holder 130. Each shelf is rotatably connected to a pin (not shown) via hub 140a, a hub 140b, etc. The pin is topped by an end gasket 141, pushing down on the hubs by virtue of its weight and the fastening means 142 (in this case the latter is a screw).

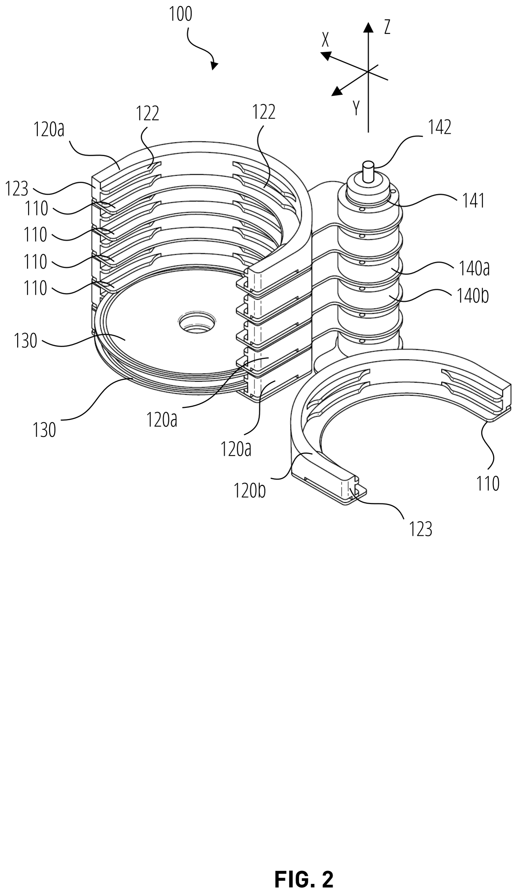

FIG. 2 provides a schematic illustration of the storage system 100 of FIG. 1 with all six removable housing positioned on the six shelves. It is possible to distinguish the removable housings 120a placed in a first predetermined position from the removable housing 120b placed in a second predetermined position in the (xy) plane perpendicular to the rotation axis (z). Each removable housing has a front side 123 adapted to ease access to the substrate holders contained therein, if present.

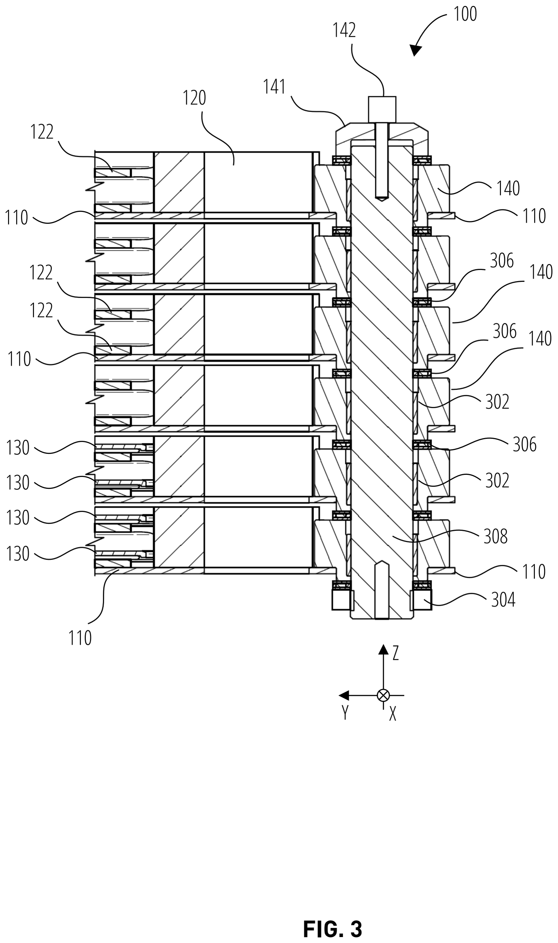

FIG. 3 provides a section of the storage system 100 of FIG. 1 with all six shelves in a same predetermined position and supporting a removable housing 120. The removable housings feature the supporting elements 122. The bottom four supporting elements, each comprising three protrusions, contain four substrate holders 130. Each shelf 110 is adapted to rotate around the pin 308 and along the rotation axis (z) with the hub 140. A bush (302) is positioned between each hub and the pin to reduce friction. For a similar reason, adjacent hubs are separated by a separator 306 provided with roller bearings (not shown).

The pin 308 is topped by an end gasket 141, pushing down on the hubs via the fastening means 142. A spacer 304 ensures the correct height of the shelves 110 with respect to a support plane.

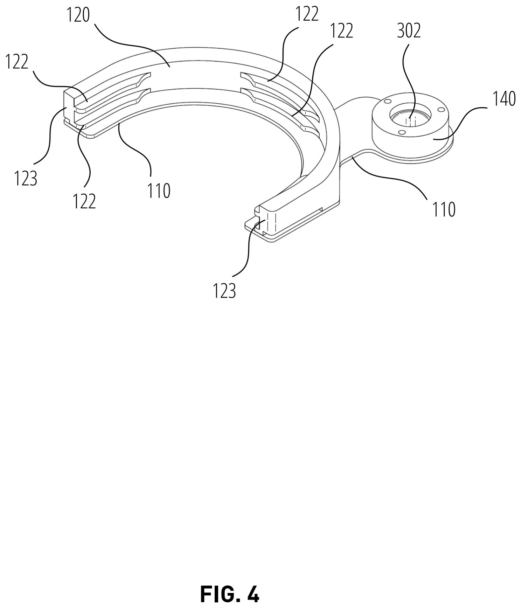

FIG. 4 provides a view of a shelf 110 comprising a hub 140, and a bush 302.

The shelf 110 supports a removable housing 120 having a front side 123. The removable housing comprises several protrusions which constitute the supporting elements 122, which in this embodiment are adapted to support two substrate holders (not shown) at a time.

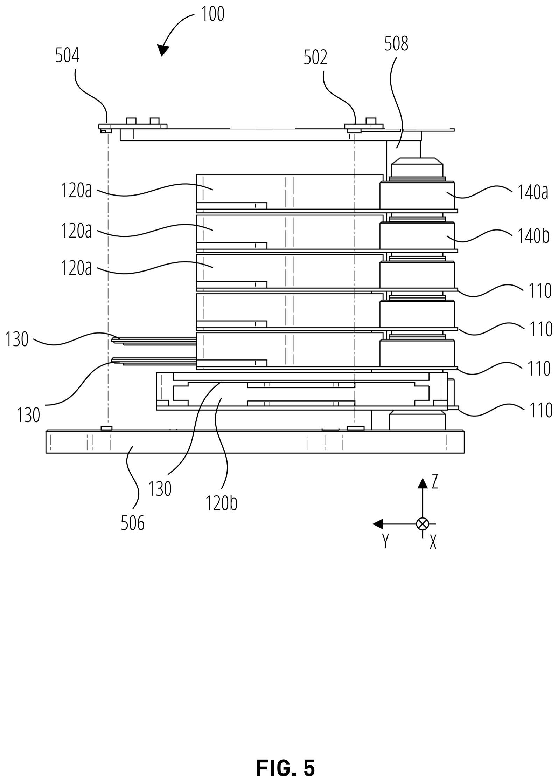

FIG. 5 provides a schematic illustration of a storage system 100 according to an embodiment of the invention. The storage system is placed on a support surface 506. It comprises a first sensor 502 which is positioned in a way to detect if a shelf is positioned in a predefined position - specifically if it is rotated in a way to be oriented along the "x" direction of the drawing.

The storage system also comprises a second sensor 504, configured to detect a displacement of at least one substrate holder 130 from a predefined location when all the shelves (and removable housings) are oriented along the "y" direction of the drawing.

The storage system also comprises a column 508 that may be used to attract the shelves in proximity of the column into a releasably locked position, for example by magnetic or electromagnetic forces. This can be done by selecting appropriate magnetic or electromagnetic materials for (or adding parts made of said materials to) the column 508 and the shelves 110.

FIG. 6 provides a schematic illustration of a reactor assembly 600 according to an embodiment of the invention. The reactor assembly comprises a substrate handling platform 602, a load-lock chamber 604, a transfer chamber 606 and a reaction chamber 608 in communication with each other.

The substrate handling platform 602 has a support surface 506 that supports:
- a storage system 100, comprising a substrate holder 130, magnets 622, and a column 508;
- a substrate centering unit 610;
- a substrate management station 614, which stores substrates 616;
- a first automatic component 612.

In this case the latter is an articulated arm adapted to grab the substrates from the substrate management station 614, the substrate holders 130 from the storage system 100, and displace them to the substrate centering unit 610 to join and center them.

This first automatic component is also configured to grab and displace the substrate holders with the substrates centered in the centering unit, to/from a load-lock chamber 604.

The load-lock chamber 604 is adapted to condition the substrates before processing and sets the substrate handling platform 602 in communication with the transfer chamber 606.

The latter comprises a cooling station 618, a heating station 620, and a second automatic component 612 which is adapted to displace the substrate holders with the substrates to/from the load-lock chamber 604, the cooling station 618, the heating station 620 and the reaction chamber 608.

## Claims

1. A storage system (100) suitable for storing a plurality of substrate holders (130), wherein said storage system comprises:
- a pin (308) extending along a rotation axis (z);
- at least two shelves (110) positioned on top of each other along a direction substantially parallel to the rotation axis (z), each shelf being adapted to support at least one removable housing (120);
wherein the shelves are pivotally connected to said pin around the rotation axis and are configured to rotate around said rotation axis independently from each other; and
wherein each removable housing is adapted to support at least one substrate holder suitable for supporting a substrate (616) for the deposition of semiconductor films, said removable housing being configured to be releasably coupled to a shelf and be withdrawn therefrom.

2. The storage system (100) of claim 1, wherein each removable housing (120) has a front side (123) and wherein said front side faces an outer side of the storage system.

3. The storage system (100) of claim 1 or 2, wherein the removable housing (120) comprises at least one supporting element (122) adapted to support at least one substrate holder (130), each supporting element comprising one or more protrusions or indentations, said supporting element being preferably configured to support a substrate holder of substantially circular shape.

4. The storage system of any one of claims 1 to 3, wherein each shelf (110) is adapted to rotate from a first predetermined position to a second predetermined position and vice versa.

5. The storage system of claim 4, wherein each shelf (110) can be releasably locked into said first predetermined position and/or said second predetermined position.

6. The storage system (100) of any one of claims 1 to 5, wherein each shelf (110) comprises a hub (140, 140a, 140b) configured to be pivotally connected to the pin (308).

7. The storage system (100) of claim 6, further comprising at least one separator (306), wherein each separator is placed between two adjacent hubs (140, 140a, 140b).

8. The storage system (100) according to any one of claims 1 to 7, further comprising a first sensor (502) configured to detect when all shelves (110) are in the first predetermined position and or the second predetermined position.

9. The storage system (100) according to any one of claims 1 to 8, further comprising a second sensor (504) configured to detect a displacement of at least one substrate holder (130) from a predefined location when all shelves are either in the first predetermined position or in the second predetermined position.

10. A substrate handling platform (602) for a reactor assembly (600), comprising:
- a support surface (506);
- at least one storage system (100) according to any one of the preceding claims;
- at least one substrate centering unit (610); and
- at least one automatic component (612) adapted to grab and transfer a substrate holder (130);
wherein said at least one storage system, said at least one substrate centering unit, and said at least one automatic component are positioned over said support surface and are mutually arranged so that both the at least one storage system and the at least one substrate centering unit can be accessed by the at least one automatic component.

11. The substrate handling platform (602) according to claim 10, further comprising a substrate management station (614) for receiving and storing substrates (616) positioned over the support surface (506) and arranged so that it can be accessed by the at least one automatic component (612).

12. A reactor assembly (600) comprising:
- at least one substrate handling platform (602) according to claim 10 or 11;
- a reactor for the deposition of semiconductor films on a substrate (616) comprising at least one reaction chamber (608);
- at least one load-lock chamber (604) for conditioning substrates;
- at least one transfer chamber (606) connected to the reaction chamber (608) and to the load-lock chamber (604); and
wherein the transfer chamber (606) comprises at least one automatic component (612) for placing a substrate holder (130), in and out of the reaction chamber.
